# EUROPÄISCHE PATENTSCHRIFT

(11) **EP 1 114 576 B1**
(45) Veröffentlichungstag und Bekanntmachung des Hinweises auf die Patenterteilung: **20.11.2002**
(21) Anmeldenummer: 99953607.1
(22) Anmeldetag: 26.08.1999
(51) Int. Cl.: H05K 13/04

(54) **VORRICHTUNG ZUM BESTÜCKEN VON SCHALTUNGSTRÄGERN**
INSERTION DEVICE FOR CIRCUIT CARRIERS
DISPOSITIF POUR EQUIPER DES SUPPORTS DE CIRCUITS

(30) Priorität: 18.09.1998 DE 19842951
(43) Veröffentlichungstag der Anmeldung: 11.07.2001
(73) Patentinhaber: Siemens Production and Logistics Systems AG, 90475 Nürnberg (DE)
(72) Erfinder: LUECKEHE, Hans-Werner, D-33154 Salzkotten (DE)
(74) Vertreter: Berg, Peter, Dipl.-Ing.
(86) Internationale Anmeldenummer: DE9902676
(87) Internationale Veröffentlichungsnummer: WO00018207

(56) Entgegenhaltungen:
- EP-A- 0 453 370
- EP-A- 0 476 577
- US-A- 5 400 497

## Beschreibung

Die Erfindung betrifft eine Vorrichtung zum Bestücken von Schaltungsträgern mit einer Anzahl von elektrischen Bauteilen, insbesondere von SMD-Bauteilen, mit einer Bestückungseinheit zum Bestücken des Schaltungsträgers mit den Bauteilen und mit einer Zuführeinheit zum Zuführen der in einem Gebinde bereitgehaltenen Bauteile.

Zum Bestücken von Schaltungsträgern werden elektrische Bauteile üblicherweise in Gebinden bereitgehalten und mittels einer Zuführeinheit einer Bestückungseinheit zugeführt. Um eine störungsfreie und kontinuierliche Zuführung zu der Bestückungseinheit zu gewährleisten, können die elektrischen Bauteile auf bandförmigen Gurten bereitgehalten sein, die von einer Rolle abrollbar sind. Um einen hohen Durchsatz zu ermöglichen, sind einer Bestückungseinheit mehrere Zuführeinheiten bzw. Gebinde zugeordnet. Zum Erkennen der korrekten Zuordnung eines Gebindes zu einer entsprechenden Zuführeinheit beim Rüsten bzw. Nachfüllen der Bestückungseinheit kann das Gebinde mit einer Barcode-Kennung versehen sein, die bauteilbezogene Daten enthält. Diese Daten können mittels eines Barcode-Lesers in eine Datenverarbeitungseinheit gelesen und dann mit den vorgegebenen Soll-Daten verglichen werden. Zwar ermöglicht diese Methode ein eindeutiges Erkennen des Typs der in Form eines Gebindes bereitgehaltenen Bauteile. Jedoch kann hierdurch nicht sicher verhindert werden, daß das überprüfte Gebinde einer falschen Zuführeinheit zugeordnet wird.

Das Dokument US-A-5 400 497, das als nachstliegender Stand der Technik angesehen wird, offenbart eine Vorrichtung mit allen im Oberbegriff des Anspruchs 1 genannten Merkmalen.

Aufgabe der vorliegenden Erfindung ist es daher, eine Vorrichtung zum Bestücken von Schaltungsträgern derart weiterzubilden, daß eine Fehlbestückung sicher vermieden wird.

Die erfindungsgemäße Lösung dieser Aufgabe ist im Anspruch 1 definiert.

Der Vorteil der Erfindung besteht insbesondere darin, daß der Identifikationsträger für das Gebinde mehrfach verwendbar ist. Nach Beenden der Bestückung kann der Identifikationsträger von dem Gebinde entfernt und einem weiteren noch zu bestückenden Gebinde zugeordnet werden. Grundgedanke der Erfindung ist es, daß die Überprüfung der korrekten Zuordnung der Gebinde unmittelbar am Ort der Bauteilzuführung zu der Bestückungeinheit erfolgt. Hierdurch kann eindeutig eine Fehlbestückung vermieden werden. Dabei werden die in dem Identifikationsträger gespeicherten bauteilbezogenen Daten auf Übereinstimmung mit in einer Kontrolleinheit vorliegenden und vorgegebenen bestückungsbezogenen Daten überprüft. Sofern eine Übereinstimmung festgestellt wird, kann durch Abgabe eines Freigabesignals eine Bestückung durch die Bauteile des entsprechenden Gebindes erfolgen. Somit kann durch eine lokale und selbsttätige Überprüfung eine etwaige manuelle Fehlbestückung infolge einer falschen Zuordnung eines Gebindes zu einer Zuführeinheit sicher vermieden werden.

Nach einer Weiterbildung der Erfindung ist der Zuführeinheit räumlich eine einzige Kontrolleinheit zugeordnet, wobei der Identifikationsträger derart ausgebildet ist, daß er in der Bestükkungsposition mit der Kontrolleinheit in Eingriff bringbar ist. Hierdurch kann sichergestellt werden, daß beim Einrüsten der Bauteile eine selbsttätige Überprüfung der korrekten Zuordnung des Gebindes erfolgen kann.

Nach einer Ausgestaltung der Erfindung ist der Identifikationsträger derart geformt, daß das Gebinde nur dann in die vorgesehene Bestückungsposition bringbar ist, wenn der Identifikationsträger in der Kontrolleinheit eingreift. Zu diesem Zweck ist der Identifikationsträger winkelförmig ausgebildet, wobei das erste Ende mit dem Gebinde mechanisch koppelbar.

Nach einer Ausgestaltung der Erfindung weist das zweite Ende des Identifikationsträgers an einer Oberfläche Kontaktflächen auf zur Kontaktierung mit entsprechend angeordneten Kontakten der Schreib/Leseeinheit. Vorzugsweise ist der Chip innerhalb des Identifikationsträgers angeordnet, so daß er vor Beschädigung geschützt ist.

Weitere Vorteile der Erfindung ergeben sich aus den weiteren Unteransprüchen.

Ein Ausführungsbeispiel der Erfindung wird nachfolgend anhand der Zeichnungen näher beschrieben.

Es zeigen:

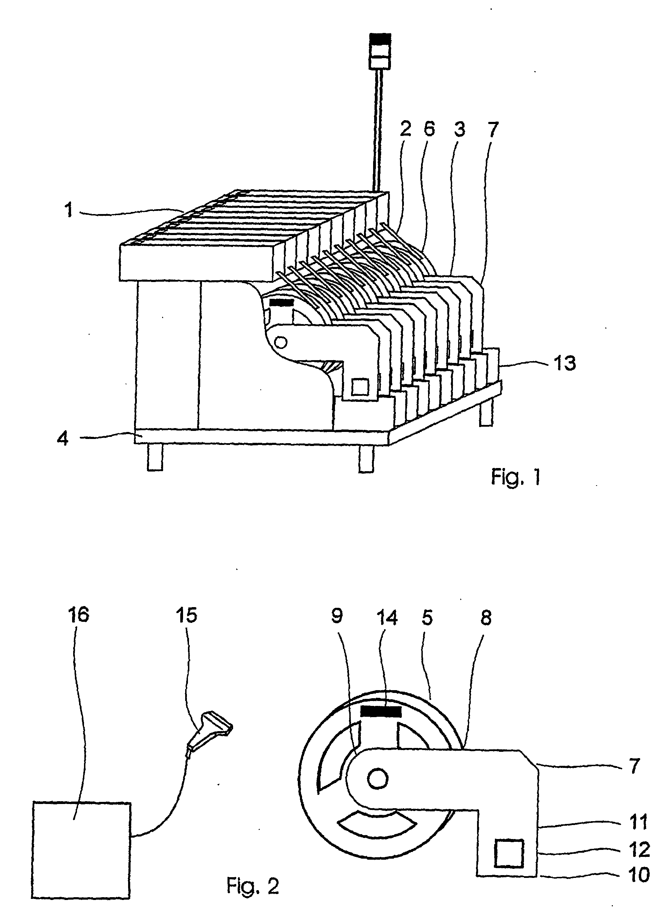

- Fig. 1: eine perspektivische Darstellung eines mit einer Anzahl von Gebinden versehenen Wechseltisches und jeweils den Gebinden zugeordneten Zuführungseinheiten für eine nachgeordnete Bestückungseinheit und
- Fig. 2: ein Gebinde mit einem Identifikationsträger, in den bauteilbezogene Daten einlesbar sind.

Die erfindungsgemäße Vorrichtung zum Bestücken von Schaltungsträgern besteht im wesentlichen aus einer nicht dargestellten Bestückungseinheit und einer Anzahl von Zuführeinheiten 1. In an sich bekannter Weise werden mittels der Zuführeinheit 1 elektrische Bauteile 2, insbesonderen SMD-Bauteile, der Bestückungseinheit zugeführt, wobei sie auf einem bereitgehaltenen Schaltungsträger, insbesondere einer Leiterplatte, an einer vorgegebenen Stelle positioniert werden. Nachdem die SMD-Bauteile 2 durch eine Lötpaste auf dem Schaltungsträger fixiert worden sind, können sie beispielsweise durch Anwendung eines Reflow-Lötverfahrens endgültig unter elektrisch leitender Verbindung mit auf dem Schaltungsträger vorgegebenen Leiterbahnen auf demselben befestigt werden.

Zur selbsttätigen Bestückung des Schaltungsträgers mit den SMD-Bauteilen 2 werden die Bauteile 2 in Form von Gebinden 3, die jeweils einer Zuführeinheit zugeordnet sind, bereitgestellt. Um einen möglichst hohen Durchsatz zu gewährleisten, werden eine Mehrzahl von Gebinden 3 auf einen Wechseltisch 4 gesetzt, und dieser in einem Zuführbereich der Bestückungseinheit derart positioniert, daß die Gebinde 3 jeweils bündig zu der als Zuführschacht ausgebildeten Zuführeinheit 1 angeordnet sind.

Die Gebinde 3 bestehen jeweils aus einer Rolle 5, auf der ein flexibler und bandförmiger Gurt 6 aufgerollt ist. Auf dem Gurt 6 befinden sich in regelmäßigen Abständen die SMD-Bauteile 2.

Das Gebinde 3 bzw. die Rolle 5 ist mit einem winkelförmigen Identifikationsträger 7 verbunden, der im wesentlichen aus einem flächigen Kunststoffmaterial besteht. Ein erstes Ende 8 des Identifikationsträgers 7 ist mittels eines Befestigungselementes 9 lösbar an der Drehachse der Rolle 5 verbunden. Ein zweites Ende 10 des Identifikationsträgers 7 weist einen in einer Aussparung des Kunststoffmaterials eingebetteten Chip auf, der elektrisch in Verbindung steht mit bündig zu einer Oberseite 11 des Identifikationsträgers 7 verlaufenden Kontaktflächen 12. Sowohl die Ausbildung des zweiten Endes 10 als auch die Anordnung der Kontaktflächen 12 an demselben entsprechen den Normen für eine Chipkarte. Hierdurch kann das zweite Ende 10 in eine übliche Schreib/Leseeinheit 13 für Chipkarten eingesteckt werden.

Im vorliegenden Ausführungsbeispiel ist jedem zweiten Ende 10 eines Gebindes 3 eine Schreib/Leseeinheit 13 zugeordnet. Die Schreib/Leseeinheiten 13 sind reihenförmig und nebeneinander angeordnet.

Die Schreib/Leseeinheit 13 bildet eine Kontrolleinheit, die zum einen eine Kontaktiereinheit zum mechanischen und elektrischen Ankoppeln des zweiten Endes 10 und zum anderen eine Steuereinheit mit einem Mikroprozessor aufweist.

Der Rüstvorgang wird im folgenden beschrieben. In einem ersten Schritt werden die als Barcode 14 auf jeweils einer Rolle 5 gespeicherten bauteilbezogenen Daten mittels eines Handscanners 15 in eine zentrale Datenverarbeitungseinheit 16 eingelesen. Die Datenverarbeitungseinheit 16 kann als Rüstplatz-Computer ausgebildet sein und einer Mehrzahl von Bestückungseinheiten zugeordnet sein. Die Datenverarbeitungseinheit 16 weist alle für die Rüstung relevanten Daten, wie z.B. Art der Bestückungseinheit, Anordnung der Zuführeinheiten an bestimmten Seiten der Bestückungseinheit etc., auf. Diese bilden die rüstbezogenen Daten, die für die korrekte Zuordnung des Gebindes 3 an die jeweilige Zuführeinheiten 1 erforderlich sind. Die bauteilbezogenen Daten werden nun von der zentralen Datenverarbeitungseinheit 16 mittels einer nicht dargestellten Schreib/Leseeinheit in den Chip des Identifikationsträgers 7 eingeschrieben. Der Chip des Identifikationsträgers 7 ist vorzugsweise als Speicherchip mit einem nichtflüchtigen Speicher (EEPROM) ausgebildet. Bei dem Beschreiben des Chips ist der Identifikationsträger 7 bereits mechanisch und unverlierbar mit der die entsprechenden Bauteile 2 aufweisenden Rolle 5 verbunden. Hierdurch wird sichergestellt, daß die als Barcode an dem betreffenden Gebinde vorliegenden bauteilbezogenen Daten, nämlich der Typ des Bauteils 2, identisch zu den in den Chip eingelesenen bauteilbezogenen Daten ist.

Zum Rüsten der Vorrichtung wählt die Bedienperson anhand der zentralen Datenverarbeitungseinheit 16 die gewünchte Rüstung aus und übermittelt die ausgewählten rüstbezogenen Daten an die jeweiligen auf dem Wechseltich 4 angeordneten Schreib/Leseeinheiten 13. Die rüstbezogenen Daten bilden die Soll-Daten für die jeweiligen später auf dem Wechseltisch 4 anzubringenden Gebinde 3.

In einem weiteren Schritt werden die Gebinde 3 entsprechend der Vorgabe der zentralen Datenverarbeitungseinheit 16 der jeweiligen Zuführeinheit 1 zugeordnet und in dem entsprechenden Fach des Wechseltisches 4 positioniert. Zur ordnungsgemäßen Positionierung muß das zweite Ende 10 in die dafür vorgesehene Schreib/Leseeinheit 13 eingesteckt werden. Nach der elektrischen Kontaktierung des Chips des Identifikationsträgers 7 in der Schreib/Leseeinheit 13 erfolgt ein Auslesen der bauteilbezogenen Daten aus dem Chip des Identifikationsträgers 7 in einen Speicher der Schreib/Leseeinheit 13. Dem Mikroprozessor in der Schreib/Leseeinheit 13 ist ein Programm zugeordnet, das einen Vergleich der bauteilbezogenen Daten mit den in der entsprechenden Schreib/Leseeinheit 13 gespeicherten bestükkungsbezogenen Daten ermöglicht. Wird eine Übereinstimmung der bauteilbezogenen Daten mit den bestückungsbezogenen Soll-Daten festgestellt, wird ein Freigabesignal erzeugt, das der Bedienperson signalisiert, daß sich das Gebinde 3 in dem vorgesehenen Schacht des Wechseltisches 4 befindet, bzw. der vorgegebenen Zuführeinheit 1 zugeordnet ist. Dieser Vergleich wird nacheinander für jedes Gebinde 3 durchgeführt.

Da das Gebinde 3 nur unter Einstecken des zweiten Endes 10 des Identifikationsträgers 7 in die Schreib/Leseeinheit 13 lagerichtig für die Zuführung angeordnet ist, ist eine oben beschriebene Überprüfung der korrekten Zuführung Bedingung für die Inbetriebnahme der Bestückungseinheit. Eine Fehlbestückung infolge von Nichtbestückung kann hierdurch sicher vermieden werden.

Alternativ kann das zweite Ende 10 auch mit an einer Stirnseite desselben reihenförmig angeordneten Kontaktflächen ausgebildet sind, die zu korrespondierenden Kontaktelementen einer Schreib/Leseeinheit positionierbar sind. Alternativ kann der Vergleich auch in der zentralen Datenverarbeitungseinheit 16 erfolgen, sofern die Schreib/Leseeinheiten 13 durch elektrische Leitungen mit derselben verbunden sind. Wesentlich an der erfindungsgemäßen Vorrichtung ist, daß der Identifikationsträger 7 mit den gespeicherten bauteilbezogenen Daten fest mit dem jeweiligen Gebinde 3 verbunden ist, so daß jederzeit und unabhängig vom Ort die bauteilbezogenen Daten mittels mobiler Schreib/Leseeinheiten überprüfbar sind.

Die Bestückung von Bauteilen 2 in Gebinden eines Wechseltisches 4 wird vorzugsweise dann freigegeben, wenn für alle Gebinde 3 des Wechseltisches 4 eine Übereinstimmung der bauteilbezogenen Daten zu den Soll-Daten festgestellt worden ist.

## Patentansprüche

1. Vorrichtung zum Bestücken von Schaltungsträgern mit einer Anzahl von elektrischen Bauteilen, insbesondere von SMD-Bauteilen, mit einer Bestückungseinheit zum Bestükken des Schaltungsträgers mit den Bauteilen und mit einer Zuführeinheit zum Zuführen der in Gebinden bereitgehaltenen Bauteile, wobei mit jedem Gebinde (3) ein Identifikationsträger (7) verbunden und der Zuführeinheit (1) eine Kontrolleinheit (13) zugeordnet ist und daß Mittel vorgesehen sind, derart, daß bauteilbezogene Daten in die Identifikationsträger (7) einspeicherbar sind und daß in der Kontrolleinheit (13) die bauteilbezogenen Daten der Gebinde (3) überprüfbar sind, **dadurch gekennzeichnet, daß** jeder Tdentifikationsträger (7) mit einem ersten Ende (9) lösbar mit dem Gebinde (3) verbunden ist und ein als Chipkarte ausgebildetes zweites Ende (10) aufweist, die mit einer Schreib-/ Leseeinheit (13) als kontrolleinheit Koppelbar ist.

2. Vorrichtung nach Anspruch 1 oder 2, **dadurch gekennzeichnet, daß** der Zuführeinheit (1) räumlich eine einzige Kontrolleinheit (13) zugeordnet ist und daß der Identifikationsträger (7) derart ausgebildet ist, daß er in der Bestückungsposition mit der Kontrolleinheit (13) in Eingriff bringbar ist.

3. Vorrichtung nach einem der Ansprüche 1 oder 2, **dadurch gekennzeichnet, daß** die Schreib/Leseeinheit mit einer zentralen Datenverarbeitungseinheit (16) elektrisch verbindbar ist.

4. Vorrichtung nach einem der Ansprüche 1 bis 3, **dadurch gekennzeichnet, daß** die Gebinde (3) mit einer bauteilbezögenen Barcode-Kennung (14) versehen sind, die mittels eines Scanners (15) lesbar ist zur Zwischenspeicherung der bauteilbezogenen Daten in einer zentralen Datenverarbeitungseinheit (16).

5. Vorrichtung nach einem der Ansprüche 1 bis 4, **dadurch gekennzeichnet, daß** das zweite Ende (10) auf einer Oberseite (11) angeordnete Kontaktflächen (12) zur Kontaktierung mit korrespondierenden Kontaktelementen der Schreib/Leseeinheit (13) aufweist.

6. Vorrichtung nach einem der Ansprüche 1 bis 5, **dadurch gekennzeichnet, daß** die Gebinde (3) zusammen mit den jeweils zugeordneten Identifikationsträgern (7) und den Schreib/Leseeinheiten (13) benachbart zueinander auf einem gemeinsamen Wechseltich (4) bereitgehalten sind.

7. Vorrichtung nach einem der Ansprüche 1 bis 6, **dadurch gekennzeichnet, daß** die Gebinde (3) als mit einer Vielzahl von Bauelementen (2) versehene Gurte (6) ausgebildet sind, die auf einer Rolle (5) aufgewickelt sind.

## Claims

1. Apparatus for placing a number of electrical components, in particular SMD components, on circuit bases, having a placement unit for placing the components on the circuit base, and having a feed unit for feeding the components, which are provided in magazines, an identification medium (7) being connected to each magazine (3) and the feed unit (1) having an associated monitoring unit (13), and in that means are provided in such a manner that component-related data can be stored in the identification medium (7), and in that the monitoring unit (13) is used to check the component-related data for the magazines (3), **characterized in that** each identification medium (7) is detachably connected by a first end (9) to the magazine (3), and has a second end, which is configured as a smart card and which can be coupled to a write/read unit (13) as a monitoring unit.

2. Apparatus according to Claim 1 or 2, **characterized in that** the feed unit (1) has a single physically associated monitoring unit (13), and **in that** the identification medium (7) is configured in such a manner that it can be engaged with the monitoring unit (13) in the placement position.

3. Apparatus according to one of Claims 1 or 2, **characterized in that** the write/read unit can be electrically connected to a central data processing unit (16).

4. Apparatus according to one of Claims 1 to 3, **characterized in that** the magazines (3) are provided with a component-related barcode tag (14) which can be read by means of a scanner (15) for buffer-storage of the component-related data in a central data processing unit (16).

5. Apparatus according to one of Claims 1 to 4, **characterized in that** the second end (10) has contact surfaces (12), arranged on an upper face (11), for making contact with corresponding contact elements on the write/read unit (13).

6. Apparatus according to one of Claims 1 to 5, **characterized in that** the magazine (3) is provided together with the respectively associated identification media (7) and the write/read units (13) adjacent to one another on a common changeover table (4).

7. Apparatus according to one of Claims 1 to 6, **characterized in that** the magazines (3) are in the form of belts (6) which are provided with a large number of components (2) and are wound on a roll (5).

## Revendications

1. Dispositif pour équiper des supports de circuit avec un certain nombre de composants électriques, notamment de composants montés en surfaces, avec une unité d'équipement pour équiper le support de circuit avec les composants et avec une unité d'amenée pour amener les composants tenus prêts en emballages, un support d'identification (7) étant relié à chaque emballage (3) et une unité de contrôle (13) associée à l'unité d'amenée (1) et des moyens étant prévus de manière telle que des données concernant le composant peuvent être enregistrées dans le support d'identification (7) et que dans l'unité de contrôle (13) les données concemant le composant de l'emballage (3) peuvent être vérifiées, **caractérisé en ce que** chacun des supports d'identification (7) est relié avec une première extrémité (9) de façon détachable à l'emballage (3) et présente une deuxième extrémité (10) conçue comme une carte à puce qui peut être couplée à une unité d'écriture / de lecture en tant qu'unité de contrôle.

2. Dispositif selon la revendication 1 ou 2, **caractérisé en ce qu'**une unique unité de contrôle (13) est associée dans l'espace à l'unité d'amenée (1) et **en ce que** le support d'identification (7) est conçu de manière telle qu'il peut être mis en prise avec l'unité de contrôle (13) dans la position d'équipement.

3. Dispositif selon l'une des revendications 1 ou 2, **caractérisé en ce que** l'unité d'écriture / de lecture peut être reliée électriquement à une unité centrale de traitement des données (16).

4. Dispositif selon l'une des revendications 1 à 3, **caractérisé en ce que** les emballages (3) sont dotés d'une identification par code à barres (14) se rapportant au composant et pouvant être lue à l'aide d'un scanner (15) pour l'enregistrement intermédiaire des données concernant le composant dans une unité centrale de traitement des données (16).

5. Dispositif selon l'une des revendications 1 à 4, **caractérisé en ce que** la deuxième extrémité (10) présente des surfaces de contact (12) disposées sur un côté supérieur (11) pour la mise en contact avec les éléments de contact correspondants de l'unité d'écriture / de lecture (13).

6. Dispositif selon l'une des revendications 1 à 5, **caractérisé en ce que** les emballages (3) ensemble avec les supports d'identification (7) à chaque fois associés et tes unités d'écriture / de lecture (13) sont tenus prêts de façon proche les'uns par rapport aux autres sur une table de changement commune (4).

7. Dispositif selon l'une des revendications 1 à 6, **caractérisé en ce que** les emballages (3) sont conçus sous forme de bandes (6) dotées d'une pluralité de composants (2), lesdites bandes étant enroulées sur un rouleau (5).
